Europäisches Patentamt

European Patent Office

Office européen des brevets

(19)

(11) Numéro de publication: **0 298 001**
**A1**

# (12) DEMANDE DE BREVET EUROPEEN

(21) Numéro de dépôt: 88420228.4

(22) Date de dépôt: 29.06.88

(51) Int. Cl.⁴: **H 01 L 29/08**
**H 01 L 29/74**

(30) Priorité: 03.07.87 FR 8709456

(43) Date de publication de la demande:
04.01.89 Bulletin 89/01

(84) Etats contractants désignés:
CH DE FR GB IT LI

(71) Demandeur: SGS-THOMSON MICROELECTRONICS S.A.
7, Avenue Galliéni
F-94250 Gentilly (FR)

(72) Inventeur: Najji, Jean-Paul
8, Quai du Pont Neuf
F-37000 Tours (FR)

(74) Mandataire: de Beaumont, Michel et al
1bis Rue Champollion
F-38000 Grenoble (FR)

(54) Thyristor ou triac à bandes de court-circuit allongées.

(57) L'invention concerne les thyristors et les triacs. Pour désensibiliser les thyristors et les triacs, il est habituel de prévoir des trous de court-circuit d'émetteur par lesquels la région de gâchette remonte à travers la région d'émetteur. Ces trous sont en général dispersés sur toute la surface de la région d'émetteur. Selon l'invention, ils sont rassemblés selon des bandes étroites telles que les bandes 30 et 32 de la figure. On constate une amélioration notable de l'uniformité d'amorçage pour les thyristors et les triacs, et, pour les triacs, une amélioration du passage de l'état conducteur vers l'état bloqué grâce à une meilleure évacuation des charges stockées durant la conduction.

FIG.3

EP 0 298 001 A1

**Description**

## THYRISTOR OU TRIAC A BANDES DE COURT-CIRCUIT ALLONGEES

La présente invention concerne les commutateurs à semiconducteurs, et plus précisément les triacs, mais dans certains cas elle peut s'appliquer aussi à des thyristors.

On rappelle qu'un triac est constitué par deux thyristors tête-bêche placés côte à côte sur une même puce semiconductrice. Chaque thyristor est constitué par la superposition de quatre couches semiconductrices de types de conductivité alternés, NPNP, qui sont respectivement une couche d'anode de type P, une couche centrale de type N commune aux deux thyristors, une couche de gâchette de type P, et une couche d'émetteur de type N. Sur la face arrière de la puce, une première métallisation principale recouvre à la fois la couche d'anode de l'un des thyristors et la couche d'émetteur de l'autre; sur la face avant, une deuxième métallisation principale recouvre à la fois la couche d'émetteur du premier thyristor et le couche d'anode de l'autre, tandis qu'une métallisation de gâchette recouvre une partie de la couche de gâchette du premier thyristor là où cette couche affleure (côté face avant).

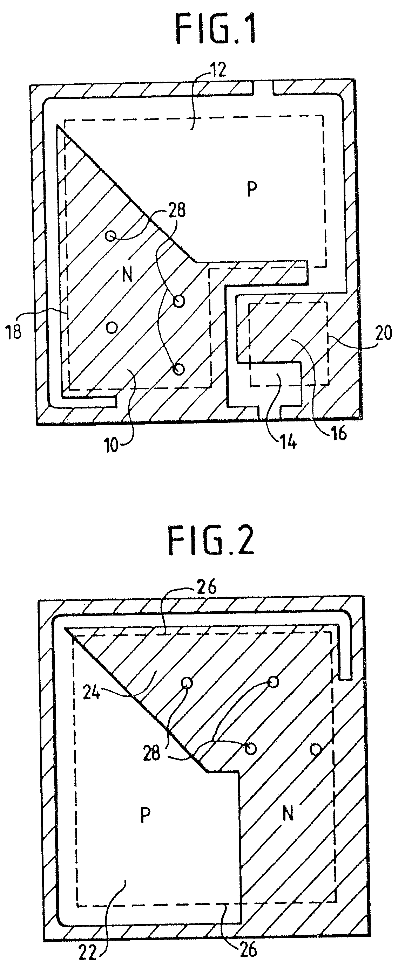

Cette disposition définit généralement la structure de tous les triacs, et on a représenté sur les figures 1 et 2 respectivement la face avant et la face arrière d'un triac classique. Plus précisément, on voit sur ces figures les zones d'affleurement des différentes couches de type N et P sur les faces avant et arrière. Les zones hachurées représentent l'affleurement de couches de type N; les zones blanches représentent l'affleurement de couches de type P. Les traits pleins délimitent la séparation de ces zones; les trais tiretés représentent le contour des métallisations qui sont en contact avec les zones semiconductrices affleurantes.

Sur la figure 1 (face avant), la référence 10 désigne l'affleurement de la couche d'émetteur du premier thyristor; la référence 12 désigne l'affleurement de la couche d'anode du deuxième thyristor; la référence 14 désigne une portion affleurante de la couche de gâchette du premier thyristor; la référence 16 désigne une portion affleurante de type N non recouverte par la première métallisation principale mais recouverte par une métallisation de gâchette.

Le contour de la première métallisation principale est représentée par le trait tireté 18; ce trait englobe la majeure partie de la région 10 et la majeure partie de la région 12.

Le contour de la métallisation de gâchette est représenté par le trait tireté 20. Il englobe la portion de région 14 et une partie de la région 16.

Comme on le voit, la face avant du triac est généralement divisée en deux zones principales séparées par une diagonale du rectangle ou du carré constituant cette face avant; la première zone contient essentiellement la région d'émetteur 10 et la premier thyristor est situé à l'aplomb de cette région; la deuxième zone contient esentiellement la région d'anode 12 et le deuxième thyristor est situé à l'aplomb de cette région. On peut voir que la même division générale existe sur la face arrière. La zone frontière entre les deux thyristors est une zone critique pour le bon fonctionnement en commutation du triac.

Sur la face arrière du triac, visible à la figure 2, on rencontre essentiellement une région affleurante 22 de type P qui fait partie de la couche d'anode du premier thyristor, et une région affleurante 24 de type N qui fait partie de la couche d'émetteur du deuxième thyristor; ces deux régions sont séparées essentiellement par une diagonale qui est à l'aplomb de la diagonale mentionnée à propos de la figure 1. Les régions 22 et 24 de la face arrière sont recouvertes par la deuxième métallisation principale dont le contour est représenté par le trait tireté 26.

Pour terminer la description du triac très classique des figures 1 et 2, on mentionnera des trous de court-circuit d'émetteur 28, qui sont des petites régions de type P remontant de la couche de gâchette vers la métallisation principale à travers la couche d'émetteur, en général aussi bien sur la face arrière que sur la face avant. Ces trous ont pour fonction d'une part d'améliorer la qualité de l'amorçage du triac en présence d'un courant de gâchette et d'autre part de favoriser le blocage du triac en permettant d'évacuer des charges stockées pendant la conduction du triac

Un but de l'invention est de proposer une disposition de trous de court-circuit qui optimise les caractéristiques d'amorçage et de blocage des triacs.

Jusqu'à maintenant, les trous de court-circuit étaient en pratique répartis assez uniformément sur la surface de la région d'émetteur à travers laquelle ils remontent. La concentration des trous était faible, car la surface cumulée globale des trous doit naturellement être limitée pour que le triac puisse conduire en dehors des trous une densité de courant suffisante. On s'est aperçu selon l'invention que l'on améliorait les caractéristiques d'amorçage et les caractéristiques de blocage en répartissant les trous non uniformément, et plus précisémént en les concentrant sous forme de bandes étroites traversant sensiblement toute la surface de la région d'émetteur. Ces bandes étroites sont de préférence continues, mais on sort pas du cadre de l'invention si elles sont discontinues pourvu que la disposition des trous corresponde essentiellement à une forte concentration de trous dans une ou plusieurs bandes étroites au lieu d'être une concentration relativement faible et uniforme comme c'était essentiellement le cas dans le passé.

Pour formuler d'une manière chiffrable la disposition selon l'invention tout en considérant de multiples dispositions pratiques qui peuvent être adoptées sans sortir de l'esprit de l'invention, on propose de définir fictivement à la surface de l'émetteur des bandes étroites susceptibles de contenir une forte concentration de trous, et d'examiner la surface cumulée globale du ou des trous dans cette bande par rapport à la surface de région d'émetteur affleurant dans la même bande. Selon l'invention, et par opposition à la technique antérieure de répartition assez uniforme, au moins une partie des trous de court-circuit sont rassemblés à l'intérieur d'au moins une bande étroite allongée s'étendant à travers la surface de la région d'émetteur, le rapport entre la superficie cumulée des trous de court-circuit dans cette bande et la superficie de la bande étant d'au moins 30%. Le rapport est de 100% si la bande étroite forme dans sa totalité un trou de court-circuit allongé.

Selon l'invention on s'est aperçu que cette disposition donnait des résultats excellents pour des triacs, et qu'elle était tout-à-fait avantageuse aussi pour des thyristors.

De préférence, une telle bande étroite à forte proportion de surface de trous est disposée le long de la frontière entre les deux thyristors tête-bêche du triac. D'autres bandes, obliques par rapport à celle-ci, peuvent être prévues.

Si les trous de court-circuit ne sont pas constitués par des bandes étroites, alors ils sont constitués par des trous carrés ou rectangulaires ou ronds (formes de trous classiques) rapprochés les uns des autres de manière à obtenir la proportion définie ci-dessus entre la superficie cumulée des trous et la superficie d'une bande étroite contenant ces trous.

D'autres caractéristiques et avantages de l'invention apparaîtront à la lecture de la description détaillée qui suit et qui est faite en référence aux dessins annexés dans lesquels:

- les figures 1 et 2, déjà décrites, représentent respectivement une vue de dessus et une vue de dessous d'un triac de type classique avec une concentration de trous faible et régulière dans la zone d'émetteur;

les figures 3 et 4 représentent respectivement en vue de dessus et en vue de dessous un triac selon l'invention avec des trous de court-circuit en forme de bandes allongées ;

les figures 5 et 6 représentent une variante de réalisation de l'invention dans laquelle les trous de court-circuit sont des bandes allongées discontinues ;

les figures 7 et 8 représentent d'autre formes de réalisation dans lesquelles les trous de court-circuit sont des trous carrés ou ronds concentrés dans des bandes étroites allongées ;

les figures 9 à 14 représentent d'autres modes de réalisation de la présente invention plus particulièrement adaptés à la structure particulière de triac décrite dans la demande de brevet PCT publiée sous le n° WO 87/00971 ; et

la figure 15 fait ressortir sous forme de courbes les avantages de la présente invention.

Sur les figures qui suivent, les références sont les mêmes qu'à la figure 1 pour les mêmes éléments.

Les trous de court-circuit d'émetteur sont ici constitués de deux bandes allongées 30 et 32 sur la face avant du triac et de deux bandes allongées 34 et 35 sur la face arrière.

Ces bandes sont des bandes étroites qui s'étendent à travers la majeure partie de la surface de la région d'émetteur.

Elles améliorent la qualité de l'amorçage du thyristor, et, pour faciliter l'évacuation des charges lors du passage du thyristor de l'état conducteur à l'état bloqué, on prévoit de préférence que la bande 30 s'étende à proximité de la frontière entre les régions affleurantes N et P contactées par la métallisation 18 de la face avant ; comme on le voit sur la figure, la bande 30 s'étend essentiellement parallèlement à cette frontière qui est diagonale.

L'autre bande 32 peut s'étendre parallèlement ou de préférence obliquement par rapport à la bande 30 ; elle traverse aussi la majeure partie de la surface de la région d'émetteur.

Sur la face arrière, les bandes 34 et 36 ont des configurations analogues respectivement aux bandes 30 et 32.

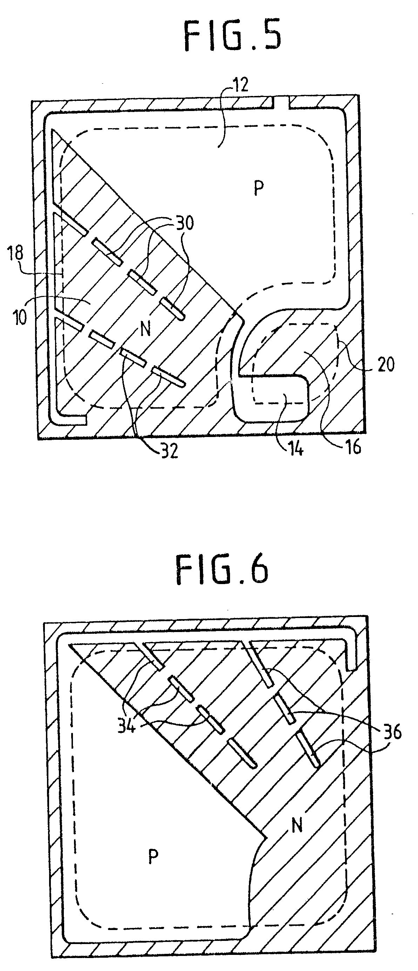

Dans des variantes de réalisation, les trous de court-circuit sont des bandes discontinues telles que celles que l'on a représenté aux figures 5 et 6.

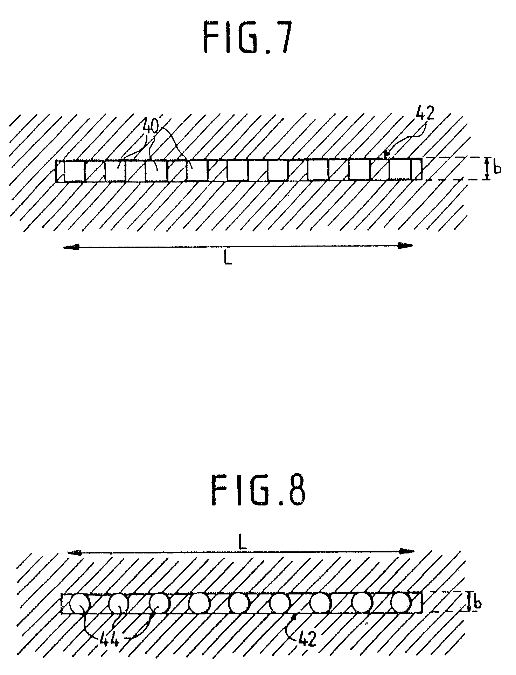

La figure 7 et la figure 8 représentent deux autres variantes de réalisation des trous de court-circuit selon l'invention ; sur la figure 7, les trous sont des trous carrés 40 et sur la figure 8 des trous ronds 44. Mais dans les deux cas, ces trous sont concentrés dans au moins une bande étroite rectangulaire et c'est cette particularité qui fait l'objet de l'invention.

Pour préciser cette particularité par rapport à ce qui se faisait dans la technique antérieure où les trous étaient dispersés et assez régulièrement répartis dans la zone d'émetteur, on peut dire qu'il est maintenant possible de définir une bande étroite 42 (fictive, c'est-à-dire non matérialisée sur la puce) qui renferme une forte concentration de trous. Par "bande étroite", il faut comprendre une bande de largeur b et de longueur L, la longueur L étant au moins 10 fois supérieure à la largeur b ; par "forte concentration de trous", il faut comprendre que la surface cumulée des trous dans la bande 42 est égale à au moins 30 % de la surface de la bande.

Autrement dit, selon l'invention, on peut définir une bande 42 de largeur b et de longueur L (L > 10b) telle que S > 0,3 L.b où S et la surface cumulée des trous.

Par exemple, dans le cas de la figure 7, s'il y a n trous carrés espacés entre eux d'une distance égale à la largeur des carrés, on peut définir une bande ayant comme largeur la largeur des carrés ; la rapport entre le surface cumulée des carrés et la surface globale de la bande contenant ces carrés est de 50 %.

La figure 8 représente un autre exemple de réalisation dans lequel les trous sont ronds et le rapport entre la surface occupée par les trous et la surface L.b de la bande est d'environ 40 %.

Les avantages de la présente invention ressortent tout particulièrement quand elle est appliquée à une structure de triac à déclenchement dans trois quadrants telle que décrite dans la demande de brevet international publiée sous le n° WO 87/00971 dont le texte sera considéré ici comme connu.

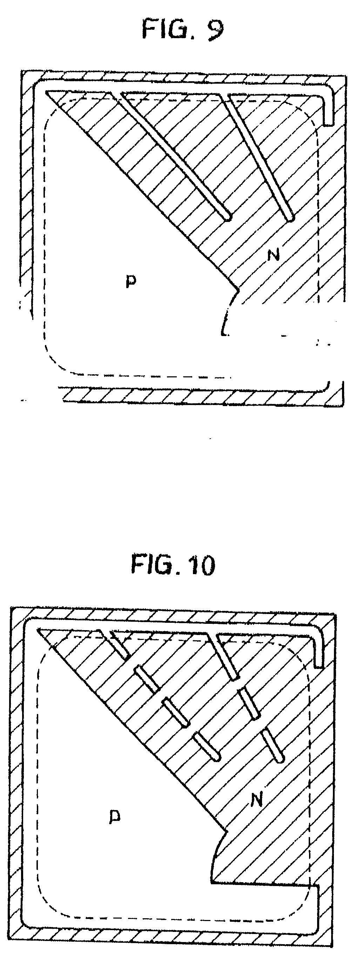

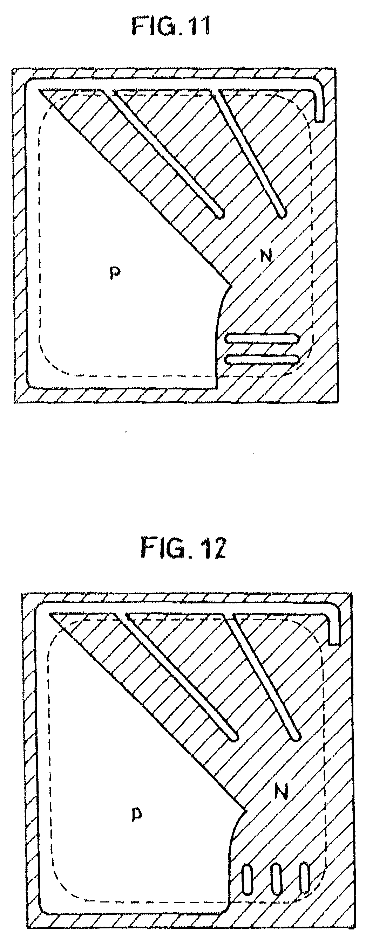

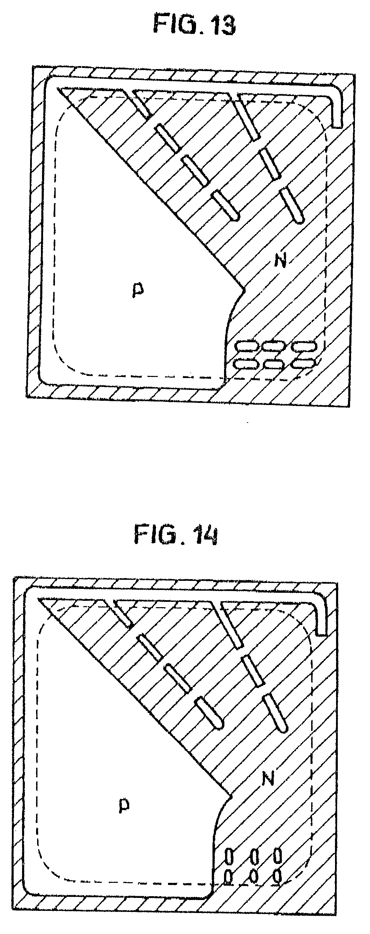

Ainsi, la structure des trous de court-circuit de la figure 8 de cette demande de brevet international peut avantageusement être modifiée conformément aux figures 9 ou 10 de la présente demande. Et la structure de la figure 11 de cette demande de brevet international pour avantageusement être modifiée de la façon représentée aux figures 11, 12, 13 ou 14 de la présente demande.

Ces figures seront aisément comprises à partir des figures précédentes de la présente demande et des figures de la demande de brevet international susmentionnée et ne seront donc pas décrites en détail ici.

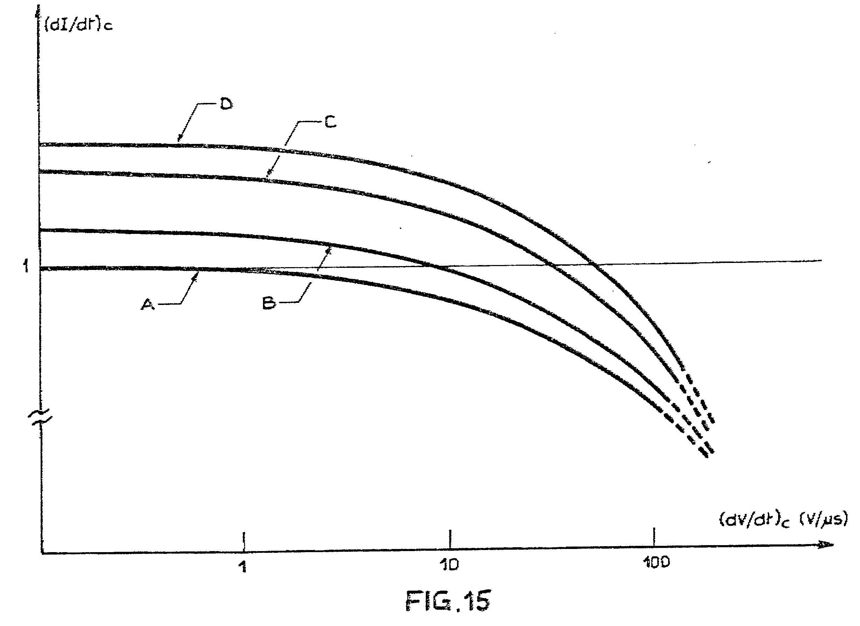

La figure 15 illustre les avantages de la présente invention. Elle indique en ordonnées la variation de courant en fonction du temps à la commutation (dI/dt)c et en abcisses la variation de tension en fonction du temps à la commutation (dU/dt)c que peut supporter un triac.

La courbe A correspond à un triac classique tel qu'illustré en figures 1 et 2 de la présente demande.

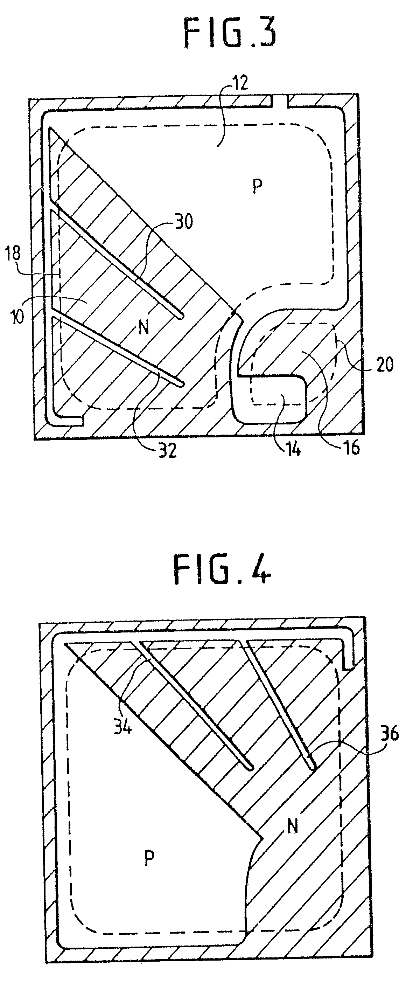

La courbe B correspond à un triac classique tel que modifié selon la présente invention en figures 3 à 6 de la présente invention.

La courbe C correspond à un triac selon la demande de brevet international susmentionnée.

La courbe D correspond à un triac tel qu'illustré en figure figures 9 à 14 de la présente demande.

On voit à partir de ces courbes que les avantages de la présente invention et de la demande de brevet international antérieure peuvent se cumuler.

## Revendications

1. Thyristor comprenant une région d'émetteur, une région de gâchette, une région centrale et une région d'anode, la région d'émetteur ayant une surface recouverte par une métallisation d'émetteur (18), avec des zones de court-circuit (30, 32, 34, 36, 40, 44) d'émetteur par lesquelles la région de gâchette remonte à travers la région d'émetteur jusqu'à la métallisation d'émetteur, caractérisé en ce qu'au moins une partie de ces zones de court-circuit d'émetteur est rassemblée à l'intérieur d'au moins une bande étroite allongée (42) s'étendant à travers la surface de la région d'émetteur, le rapport entre la superficie cumulée des zones de court-circuit dans cette bande et la superficie de cette bande étant d'au moins 30 %.

2. Triac comprenant deux thyristors tête-bêche juxtaposés dans un même substrat semiconducteur, chacun des thyristors comportant une région d'émetteur, une région de gâchette, une région centrale commune aux deux thyristors, une région d'anode, et la région d'émetteur ayant une surface recouverte par une métallisation d'émetteur (18), l'un au moins des thyristors comportant des zones de court-circuit (30, 32, 34, 36, 40, 44) par lesquelles sa région de gâchette remonte à travers sa région d'émetteur jusqu'à sa métallisation d'émetteur, caractérisé en ce qu'au moins une partie de ces zones de court-circuit d'émetteur est rassemblée à l'intérieur d'au moins une bande étroite allongée (42) s'étendant à travers la surface de la région d'émetteur, le rapport entre la superficie cumulée des zones de court-circuit dans cette bande et la superficie globale de la bande étant d'au moins 30 %.

3. Triac selon la revendication 2, caractérisé en ce que la bande étroite allongée est située essentiellement parallèlement à un plan de séparation des deux thyristors du triac et à proximité de ce plan.

4. Triac selon la revendication 3, caractérisé en ce qu'il comporte au moins une autre bande étroite s'étendant obliquement par rapport à la première.

5. Triac selon l'une des revendications 1 à 4, caractérisé en ce que au moins une zone de court-circuit est constituée en forme de bande étroite allongée.

0298001

# FIG.1

# FIG.2

# FIG.3

# FIG.4

0298001

# FIG.5

# FIG.6

# FIG.7

L

# FIG.8

L

0298001

## FIG. 9

## FIG. 10

FIG.11

FIG. 12

0298001

## FIG. 13

## FIG. 14

FIG.15

Office européen
des brevets

RAPPORT DE RECHERCHE EUROPEENNE

Numero de la demande

EP 88 42 0228

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 035 841 (WESTINGHOUSE BRAKE AND SIGNAL CO., LTD) * Page 11, lignes 3-18; figures 4b,5a * --- | 1 | H 01 L 29/08 H 01 L 29/74 |
| X | FR-A-2 137 666 (SIEMENS AG) * Page 3, ligne 9 - page 4, ligne 24; figures 2-4 * --- | 1 | |
| A | US-A-3 792 320 (HUTSON) * Colonne 4, ligne 56 - colonne 5, ligne 64; figures 3-5 * --- | 1,2 | |
| A,D | WO-A-8 700 971 (THOMSON-CSF) * Figures 8,9 * ----- | 1,2 | |

DOMAINES TECHNIQUES RECHERCHES (Int. Cl.4)

H 01 L

Le présent rapport a été établi pour toutes les revendications

| Lieu de la recherche | Date d'achèvement de la recherche | Examinateur |
|---|---|---|
| LA HAYE | 29-09-1988 | BAILLET B.J.R. |

EPO FORM 1503 03.82 (P0402)